# EUROPEAN PATENT SPECIFICATION

(11) **EP 3 316 274 B1**
(45) Date of publication and mention of the grant of the patent: **26.09.2018**
(21) Application number: 16196288.1
(22) Date of filing: 28.10.2016
(51) Int. Cl.: H01H 47/32, H02M 3/158

(54) **DRIVER CIRCUIT FOR THE OPERATION OF A RELAY**
TREIBERSCHALTUNG ZUM BETRIEB EINES RELAIS
CIRCUIT D'ATTAQUE POUR LE FONCTIONNEMENT D'UN RELAIS

(43) Date of publication of application: 02.05.2018
(73) Proprietor: Samsung SDI Co., Ltd., Giheung-gu Yongin-si, Gyeonggi-do 17084 (KR)
(72) Inventor: Pretschuh, Markus, 8020 Graz (AT); Hofer, Maximilian, 8230 Hartberg (AT)
(74) Representative: Gulde & Partner

(56) References cited:
- EP-A2- 2 840 584
- US-A- 5 957 374

## Description

### Field of the Invention

The present invention relates to a driver circuit for the operation of a relay, the driver circuit comprises a voltage output for the electrical connection with a relay, a first voltage input which is separably electrically connected to the voltage output and a buck boost converter, comprising at least one input and a first output. Further, the driver circuit comprises a system basis chip, comprising an output terminal adapted to provide for a voltage. The at least one input of the buck boost converter is connected to the output terminal of the system basis chip.

### Technological Background

In battery systems of the state of the art, especially in battery systems of automotive vehicles, pulse width modulated (PWM) signals are often used to drive relays in a so called low power mode, which is often also described as an economic mode. PWM signal drives for relays have the disadvantage that big filters at the input of the power supply of the drives are needed which usually require electrolytic capacitors. Such capacitors can have a negative influence on the overall system lifetime, since they are prone to a multitude of effects causing aging and degradation. Furthermore, the design of such PWM signal drives is complex and requires a plurality of components, e.g. for the aforementioned filtering, which results in high costs of production and procurement. Moreover, a PWM signal of for example 20kHz may also negatively influence the EMC performance of for example a battery system.

US 5 957 374 A discloses a driver circuit for the operation of a relay, comprising a voltage output for the electrical connection with the relay, a first voltage input connected to the voltage output, a boost converter comprising at least one input and a first output, a system basis chip comprising an output terminal adapted to provide for a voltage, wherein the at least one input of the boost converter is connected to the output terminal of the system basis chip, the first output of the boost converter is electrically connected to the first voltage input.

### Summary of Invention

One or more of the drawbacks of the prior art could be avoided or at least reduced by means of the present invention. In particular, it is provided a driver circuit for the operation of a relay, the driver circuit comprises: a voltage output for the electrical connection with a relay and a first voltage input which is separably electrically connected to the voltage output. Furthermore, the driver circuit comprises a buck boost converter, comprising at least one input and a first output. Moreover, the driver circuit comprises a system basis chip, comprising an output terminal adapted to provide for a voltage. The at least one input of the buck boost converter is connected to the output terminal of the system basis chip. The first output of the buck boost converter is electrically connected to the first voltage input.

In such an embodiment, a plurality of components can be omitted within for example a battery system, as a relay can be advantageously operated using a system basis chip which is already implemented within the system. Thus, no additional PWM signal drive needs to be provided to operate the relay which increases the overall system lifetime and substantially reduces the cost of production and procurement regarding the driver circuit.

Preferably, the system basis chip and the buck boost converter are realized within a single integrated circuit. In such an embodiment, the driver circuit can be implemented as a single coherent component which allows for a compact design of the driver circuit.

In a preferred embodiment, the buck boost converter is adapted to provide for a PRE-voltage at the first output of the buck boost converter. Furthermore preferred, the integrated circuit is adapted to provide a PRE-voltage of the integrated circuit at the first output of the buck boost converter. In general, a system basis chip is used to support different functionalities of a system, for example of a battery system. Some of these functionalities are directed to the voltage supply around a microcontroller which is often part of the system as well. Usually, different supply voltage levels are provided for the microcontroller of a system by the system basis chip. For example, such supplied voltage levels can comprise a 5V AUX voltage or expressed in other words, a 5V voltage for an AUX-input, a 3,3V IO voltage or a 1,25V core voltage. To generate these voltage levels, the system basis chip is using a PRE voltage, which represents a basis voltage of the integrated circuit of which the other voltages are derived from. The PRE voltage is a pre stage of the other voltage stages in a buck boost configuration. Such a PRE voltage can advantageously be used to operate a relay since it has a value which is close to the value needed to operate the relay in an economic mode.

Preferably, a PRE-voltage of a system basis chip is understood to be a voltage which is used as a basis for all output voltages of the system basis chip.

Preferably, in operation, the PRE voltage has a value of V_{PRE} ∈ [6V; 7V]. Preferably, in operation, the PRE-voltage has a value of V_{PRE} ≈ 6,5V. Even more preferred, the PRE-voltage has a value of V_{PRE} = 6,5V. In such an embodiment, the PRE-voltage can directly be used to operate the relay in an economic mode. Furthermore, such a voltage is ideal to drive a relay for 48V or 12V applications.

In a preferred embodiment, the PRE-voltage is also used for the provision of at least one supply voltage for a microcontroller. In such an embodiment, the PRE-voltage is used for multiple purposes which increases the overall efficiency of the system and reduces the cost of manufacturing/production of the same.

Preferably, the driver circuit further comprises a second voltage input which is separably electrically connected to the voltage output of the driver circuit, wherein the buck boost converter comprises a second output being electrically connected to the second voltage input of the driver circuit. In such an embodiment, the driver circuit allows for the provision of two different voltage levels, for example for the provision of a high start-up voltage which assures a safe transition from the open to the closed state of the relay and for the provision of a lower non-release voltage adapted to hold the relay in the closed state.

In a preferred embodiment, the buck boost converter is adapted to provide a second voltage at the second output of the buck boost converter, wherein the second voltage is greater than a voltage providable to the first output of the buck boost converter. In such an embodiment, the second voltage can be used as the aforementioned start-up voltage wherein the PRE-voltage can be used as the aforementioned non-release voltage.

Preferably, the second voltage is greater than the PRE-voltage. In such an embodiment, the secure closure of a relay can be assured.

In a preferred embodiment, the second voltage has a value of V2 ∈ [11V; 13V]. Preferably, the second voltage has a value of V2 ≈ 12V. Furthermore preferred, the second voltage has a value of V2 = 12V. Such a voltage is ideal for the closure of a relay for 48V or 12V applications.

Preferably, the electrically conductive path between the second voltage input and the voltage output comprises a first diode. Furthermore preferred, the electrically conductive path between the second voltage input and the voltage output of the driver circuit comprises a first diode. In such an embodiment, reverse currents given within the electrically conductive path between the second voltage input and the voltage output of the driver circuit are prevented.

In a preferred embodiment, the electrically conductive path between the second voltage input and the voltage output comprises a first switch. Preferably, the first switch is realized as a field effect transistor (FET), especially preferred as a MOSFET. With such a switch, the electrically conductive path can effectively and easily be interrupted. Furthermore, FETs and especially MOSFETs can easily be realized as an integrated component and are cost-efficient.

Preferably, the electrically conductive path between the first voltage input and the voltage output of the driver circuit comprises a second diode. In such an embodiment, reverse currents given within the electrically conductive path between the first voltage input and the voltage output of the driver circuit are prevented.

In a preferred embodiment, the driver circuit further comprises at least one free wheeling diode. In such an embodiment, fast free wheeling is realized and the components of the driver circuit are protected against an excess voltage.

Preferably, the electrically conductive path between the first voltage input and the voltage output of the driver circuit comprises a second switch. Preferably, the second switch is realized as a field effect transistor (FET), especially preferred as a MOSFET. With such a switch, the electrically conductive path between the first voltage input and the voltage output of the driver circuit can effectively and easily be interrupted. Furthermore, FETs can easily be realized as an integrated component and are cost-efficient.

Moreover, it is provided a method for the operation of a relay with a driver circuit according to the invention, the driver circuit comprising the steps of: closing the first switch for a predefined period of time T, thereby transferring the relay into a closed state. Closing the second switch after the predefined period of time T. Opening the first switch again after the second switch has been closed while maintaining the second switch in a closed state. Such a method allows for the efficient operation of a relay, using the PRE voltage of a system basis chip.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a first embodiment of a driver circuit according to a first embodiment of the invention;
- Fig. 2: illustrates a system basis chip of a driver circuit according to a second embodiment of the invention;
- Fig. 3: illustrates the electrically conductive paths of the driver circuit according to the second embodiment of the invention; and
- Fig. 4: illustrates the combination of the system basis chip shown in fig. 2 and of the conductive paths of the driver circuit shown in fig. 3, forming the second embodiment of the driver circuit.

### Detailed Description of the Invention

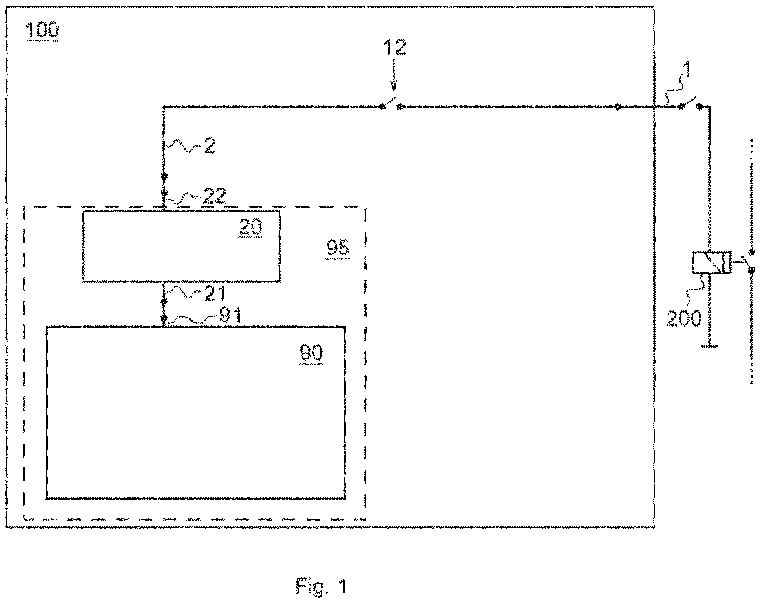

In figure 1 it is illustrated a first embodiment of a driver circuit 100 according to a first embodiment of the invention. The driver circuit 100 is adapted for the operation of a relay 200 which in figure 1 is indicated in a state in which it is not connected to the driver circuit 100. The driver circuit 100 comprises a voltage output 1 for the electrical connection with a relay 200. Thus, a voltage output 1 of the driver circuit 100 can be electrically connected to a terminal of the relay 200 shown in figure 1. Furthermore, the driver circuit 100 comprises a first voltage input 2 which is separably electrically connected to the voltage output 1. In this first embodiment, a switch 12 is arranged within the electrically conductive path between the first voltage input 2 and the voltage output 1. The switch 12 allows for the separation of the first voltage input 2 from the voltage output 1. Moreover, the driver circuit 100 comprises a buck boost converter 20, comprising at least one input 21 and a first output 22, wherein the first output 22 of the buck boost converter 20 is electrically connected to the first voltage input 2. The components of the buck boost converter 20 are not shown in figure 1, where the buck boost converter 20 is only schematically indicated. However, the buck boost converter 20 shown in figure 1 is a type of DC-to-DC converter that has an output voltage magnitude that in this embodiment is exemplarily greater than the input voltage magnitude. It is equivalent to a flyback converter using a single inductor instead of a transformer (not shown).

Further, the driver circuit 100 comprises a system basis chip 90, comprising an output terminal 91 adapted to provide for a voltage. In this first embodiment, the system basis chip 90 exemplarily is an integrated circuit that includes various functions of automotive electronic control units (ECU) on a single die. In this first embodiment, the system basis chip 90 among others is also adapted to provide for a voltage for a microcontroller (not shown). The input 21 of the buck boost converter 20 is connected to the output terminal 91 of the system basis chip 90.

In this first embodiment, the system basis chip 90 and the buck boost converter 20 are realized within a single integrated circuit 95. Expressed in other words, the system basis chip 90 and the buck boost converter 20 are realized on the same, single die and form a single integrated component. At the output terminal 91, the system basis chip 90 outputs an output voltage, providing the input 21 of the buck boost converter 20 with the output voltage. Therefore, the system basis chip 90 provides for an input voltage for the buck boost converter 20 which is adapted to convert the input voltage at the input 21 into a driving voltage for the relay 200, providing this driving voltage at the first output 22 of the buck boost converter 20.

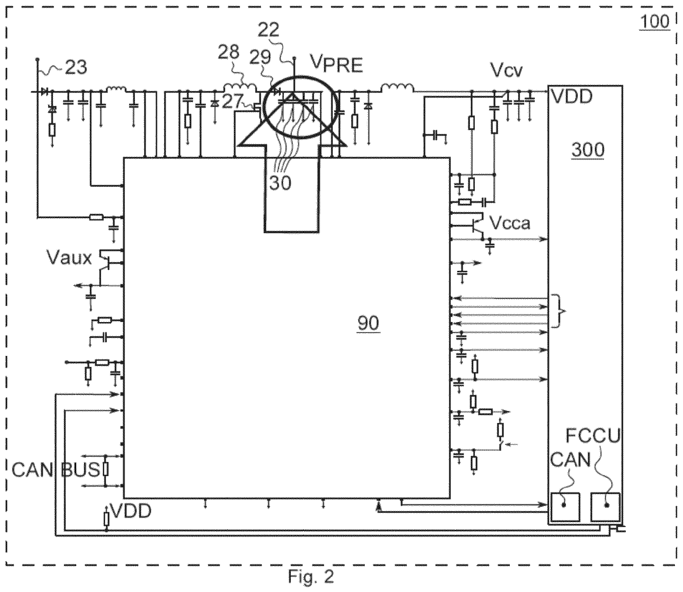

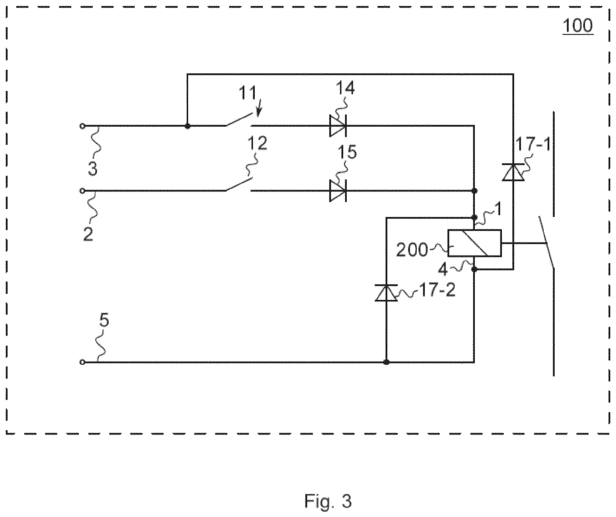

In figures 2 and 3, different parts of a second embodiment of a driver circuit 100 are shown. In figure 2, a system basis chip 90 with a buck boost converter 20 forming a first part of a driver circuit 100 according to a second embodiment of the invention is shown. The first part of the driver circuit 100 shown in figure 2 is substantially identical to the corresponding part of the driver circuit 100 shown in figure 1. Thus, in the figures, same reference signs indicate same components in each of the figures.

In more detail, in figure 2, the system basis chip 90 of the second embodiment of a driver circuit 100 is shown with a plurality of components that among others allow for the provision of different supply voltage levels for a microcontroller 300 which is also shown in figure 2. The components of the buck boost converter 20 which are in part shown in figure 2 are connected to different terminals of the system basis chip 90 respectively. In this second embodiment, the buck boost converter 20 among others comprises a field effect transistor 27 with a gate-terminal which is electrically connected to a corresponding terminal of the system basis chip 90. A drain terminal of the field effect transistor 27 is electrically connected to a terminal of an inductor 28 and to the anode of a diode 29. The cathode of the diode 29 is electrically connected to four capacitors 30 connected in parallel with each other. In figure 2, the capacitors 30 of the buck boost converter 20 are encircled and a first output 22 of the buck boost converter 20 is indicated via an arrow. Further other components of the buck boost converter 20 are not shown in figure 2 and/or not described hereinafter, since they can vary in their arrangement from chip to chip and are not important for the understanding of the invention.

In this second embodiment, the buck boost converter 20 is adapted to provide for a PRE-voltage V_{PRE} at the first output 22 of the same. The PRE-voltage V_{PRE} exemplarily has a value of V_{PRE} ∈ [6V; 7V], in more detail of V_{PRE} = 6,5V. The PRE-voltage V_{PRE} is provided via a conversion of a voltage inputted by the system basis chip 90. However, the PRE-voltage V_{PRE} is a pre stage V_{PRE} of the other stages in the buck boost configuration. Therefore the accuracy of the PRE-voltage is not very high. In this second embodiment, the PRE-voltage V_{PRE} is a voltage around 6,5V. However, in other embodiments, other PRE-voltages V_{PRE} can be realized. Such other PRE-voltages can be greater or smaller than the PRE-voltage provided by the buck boost converter 20 shown in figure 2.

The PRE-voltage V_{PRE} is also used as a basis supply voltage for the microcontroller 300. Expressed in other words, the PRE-voltage V_{PRE} is also used for the provision of a supply voltage or of a plurality of different supply voltages for the microcontroller 300. Furthermore, in this second embodiment, the system basis chip 90 is also adapted to provide for other supply voltages for the microcontroller 300. For example, the system basis chip 90 comprises a boost converter which is adapted to provide for a core voltage of Vcv = 1,25V. Furthermore, the system basis chip 90 also comprises different low-dropout regulators (LDOs), adapted to provide for a voltage Vₐᵤₓ = 3,3V and for a voltage V_{cca} = 5V.

In this second embodiment, the buck boost converter 20 comprises a second output 23 being electrically connected to a second voltage input (not shown in fig. 2) of the driver circuit 100 which will be described in greater detail hereinafter. The buck boost converter 20 is adapted to provide for a second voltage V2 at the second output 23 of the buck boost converter 20, wherein the second voltage V2 is greater than a voltage providable at the first output 22 of the buck boost converter 20. Expressed in other words, the second voltage V2 which is providable at the second output 23 of the buck boost converter 20 is greater than the PRE-voltage V_{PRE}. In this second embodiment, the second voltage has a value of V2 ∈ [11V; 13V], in more detail of 12V.

Moreover, in this second embodiment, the system basis chip 90 is exemplarily realized as a multi-output, power supply and integrated circuit device, including HSCAN and LIN transceivers, which is dedicated to the automotive market. However, also other system basis chips 90 can come to use and the invention is not restricted to the system basis chip 90 shown in figure 2.

In figure 3, the electrically conductive paths of the driver circuit 100 according to the second embodiment of the invention are shown. Expressed in other words, while a first part of the second embodiment of the driver circuit 100 is shown in figure 2, a second part of this second embodiment is shown in figure 3. In this second embodiment, the driver circuit 100 also comprises a voltage output 1 which in figure 3 is connected to the first terminal of a relay 200. The relay 200 is used in a battery system application and allows for the switching of high currents. In this second embodiment, the battery system application exemplarily comprises the battery of a vehicle. Furthermore, the driver circuit 100 comprises a first voltage input 2 and a second voltage input 3 which are both separably electrically connected to the voltage output 1 of the driver circuit 100 respectively. The driver circuit 100 further comprises a buck boost converter 20 (not shown in fig. 3) which comprises a first and a second output 22, 23 and which has been described hereinbefore with respect to figure 2. Furthermore, the driver circuit 100 comprises a system basis chip 90 with an output terminal 91 (not shown in fig. 3) that is connected to an input 21 of the buck boost converter 20 and which also has been described with respect to figure 2.

In this second embodiment, the electrically conductive path between the second voltage input 3 and the voltage output 1 comprises a first diode 14 and a first switch 11. Analogously, the electrically conductive path between the first voltage input 2 and the voltage output 1 of the driver circuit 100 comprises a second diode 15 and a second switch 12. The anode of the first diode 14 is electrically connected with a first terminal of the first switch 11, wherein the cathode of the first diode 14 is electrically connected with the voltage output 1 of the driver circuit 100. The anode of the second diode 15 is electrically connected with a first terminal of the second switch 12, wherein the cathode of the second diode 15 is electrically connected with the voltage output 1 of the driver circuit 100. The remaining second terminal of the first switch 11 is electrically connected to the second voltage input 3, wherein the remaining second terminal of the second switch 12 is electrically connected to the first voltage input 2.

Via the first switch 11, the second voltage input 3 can be reversibly separated from the voltage output 1. Via the second switch 12, the first voltage input 2 can be reversibly separated from the voltage output 1. Moreover, in this second embodiment, the driver circuit 100 comprises an optional second voltage output 4 which is also adapted for the electrical connection with a relay 200. In this second embodiment, the second voltage output 4 is connected to a further terminal of the relay 200. Furthermore, the driver circuit 100 comprises an optional third voltage input 5 electrically connected to the second voltage output 4. In this second embodiment, the optional third voltage input 5 is electrically connected to the GND potential, thereby grounding the further terminal of the relay 200.

Furthermore, the driver circuit 100 comprises two optional free wheeling diodes 17-1, 17-2 which protect the components of the driver circuit 100 from excess voltages. The anode of the first free wheeling diode 17-1 is electrically connected to the second voltage output 4, wherein the cathode of the first free wheeling diode 17-1 is electrically connected to the second voltage input 3. The anode of the second free wheeling diode 17-2 is electrically connected to the third voltage input 5, wherein the cathode of the second free wheeling diode 17-2 is electrically connected to the first voltage output 1 of the driver circuit 100.

According to the invention, the first voltage input 2 of the driver circuit 100 is electrically connected to the first output 22 of the buck boost converter 20. The second voltage input 3 of the driver circuit 100 is electrically connected to the second output 23 of the buck boost converter 20. Thus, when the first switch 11 is closed for a predefined period of time T, a voltage of 12 V is provided at the first voltage output 1, causing the relay 200 to be pulled into a closed state. The period of time T must be great enough to transfer the relay 200 into the closed state. When the relay 200 has been transferred into the closed state, the second switch 12 can be closed after the predefined period of time T. When the second switch 12 is closed, the PRE-voltage V_{PRE} is provided to the first voltage output 1, allowing to hold the relay 200 in the closed state. Thus, the first switch 11 can be opened again while the second switch 12 is maintained in the closed state. In such a state, the driver circuit 100 operates in an economic mode since the power consumed during the holding of the relay 200 with the PRE-voltage V_{PRE} is reduced.

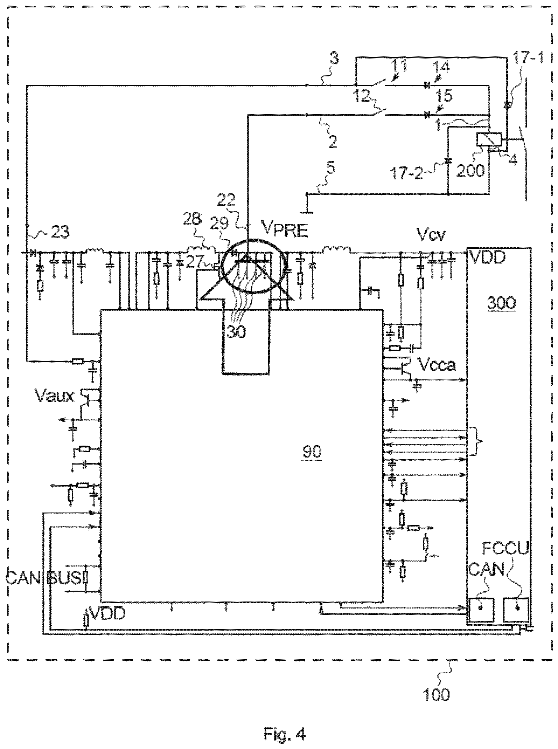

In figure 4, a schematic combination of the system basis chip 90 shown in figure 2 and of the electrically conductive paths of the driver circuit 100 according to the second embodiment of the invention is shown. In more detail, figure 4 shows the first part of the second embodiment of the driver circuit 100 as shown in figure 2 in combination with the second part of the second embodiment of the driver circuit 100 as shown in figure 3. Thus, figure 4 shows the complete second embodiment of a driver circuit 100 as described hereinbefore. Therefore, the first voltage input 2 of the driver circuit 100 is electrically connected to the first output 22 of the buck boost converter 20. The second voltage input 3 of the driver circuit 100 is electrically connected to the second output 23 of the buck boost converter 20 and the optional third voltage input 5 is electrically connected to the GND potential.

## Claims

1. A driver circuit (100) for the operation of a relay (200), the driver circuit (100) comprises:
- a voltage output (1) for the electrical connection with a relay (200);
- a first voltage input (2) which is separably electrically connected to the voltage output (1);
- a buck boost converter (20), comprising at least one input (21) and a first output (22);
- a system basis chip (90), comprising an output terminal (91) adapted to provide for a voltage, wherein the at least one input (21) of the buck boost converter (20) is connected to the output terminal (91) of the system basis chip (90),
the first output (22) of the buck boost converter (20) is electrically connected to the first voltage input (2).

2. The driver circuit (100) of claim 1, wherein the system basis chip (90) and the buck boost converter (20) are realized within a single integrated circuit (95).

3. The driver circuit (100) of any one of the previous claims, wherein the buck boost converter (20) is adapted to provide for a PRE-voltage (V_{PRE}) at the first output (22) of the buck boost converter (20).

4. The driver circuit (100) of claim 3, wherein in operation, the PRE-voltage (V_{PRE}) has a value of V_{PRE} ∈ [6V; 7V].

5. The driver circuit (100) of claim 3 or 4, wherein the PRE-voltage (V_{PRE}) is also used for the provision of at least one supply voltage for a microcontroller (300).

6. The driver circuit (100) of any one of the previous claim, further comprising a second voltage input (3) which is separably electrically connected to the voltage output (1) of the driver circuit (100), wherein the buck boost converter (20) comprises a second output (23) being electrically connected to the second voltage input (3) of the driver circuit (100).

7. The driver circuit (100) of claim 6, wherein the buck boost converter (20) is adapted to provide a second voltage (V2) at the second output (23) of the buck boost converter (20), wherein the second voltage (V2) is greater than a voltage providable to the first output (22) of the buck boost converter (20).

8. The driver circuit (100) of claim 7 and of one of the claims 3 to 5, wherein the second voltage (V2) is greater than the PRE-voltage (V_{PRE}).

9. The driver circuit (100) of claim 7 or 8, wherein the second voltage has a value of V2 ∈ [11V; 13V].

10. The driver circuit (100) of one of the claims 6 to 9, wherein the electrically conductive path between the second voltage input (3) and the voltage output (1) comprises a first diode (14).

11. The driver circuit (100) of one of the claims 6 to 10, wherein the electrically conductive path between the second voltage input (3) and the voltage output (1) comprises a first switch (11).

12. The driver circuit (100) of any one of the previous claims, wherein the electrically conductive path between the first voltage input (2) and the voltage output (1) of the driver circuit (100) comprises a second diode (15).

13. The driver circuit (100) of any one of the previous claims, further comprising at least one free wheeling diode (17).

14. The driver circuit (100) of any one of the previous claims, wherein the electrically conductive path between the first voltage input (2) and the voltage output (1) of the driver circuit (100) comprises a second switch (12).

15. A method for the operation of a relay (200) with a driver circuit (100) according to the claims 11 and 14, comprising the steps of:
closing the first switch (11) for a predefined period of time T, thereby transferring the relay (200) into a closed state;
closing the second switch (12) after the predefined period of time T;
opening the first switch (11) again after the second switch (12) has been closed while maintaining the second switch (12) in a closed state.

## Patentansprüche

1. Eine Treiberschaltung (100) zum Betreiben eines Relais (200), wobei die Treiberschaltung (100) aufweist:
- einen Spannungsausgang (1) zur elektrischen Verbindung mit einem Relais (200);
- einen ersten Spannungseingang (2), der mit dem Spannungsausgang (1) trennbar elektrisch verbunden ist;
- einen Tief-Hochsetzsteller (20), der zumindest einen Eingang (21) und einen ersten Ausgang (22) aufweist;
- einen Systembasischip (90), der einen Ausgangsanschluss (91), der angepasst ist, um eine Spannung bereitzustellen, aufweist, wobei der zumindest eine Eingang (21) des Tief-Hochsetzstellers (20) mit dem Ausgangsanschluss (91) des Systembasischips (90) verbunden ist,
wobei der erste Ausgang (22) des Tief-Hochsetzstellers (20) mit dem ersten Spannungseingang (2) elektrisch verbunden ist.

2. Die Treiberschaltung (100) nach Anspruch 1, wobei der Systembasischip (90) und der Tief-Hochsetzsteller (20) in einer einzigen integrierten Schaltung (95) realisiert sind.

3. Die Treiberschaltung (100) nach einem der vorhergehenden Ansprüche, wobei der Tief-Hochsetzsteller (20) angepasst ist, um eine PRE-Spannung (V_{PRE}) am ersten Ausgang (22) des Tief-Hochsetzstellers (20) bereitzustellen.

4. Die Treiberschaltung (100) nach Anspruch 3, wobei im Betrieb die PRE-Spannung (V_{PRE}) einen Wert von V_{PRE} ∈ [6V; 7V] aufweist.

5. Die Treiberschaltung (100) nach Anspruch 3 oder 4, wobei die PRE-Spannung (V_{PRE}) zudem für die Bereitstellung zumindest einer Versorgungsspannung für einen Mikrocontroller (300) verwendet wird.

6. Die Treiberschaltung (100) nach einem der vorhergehenden Ansprüche, ferner aufweisend einen zweiten Spannungseingang (3), der mit dem Spannungsausgang (1) der Treiberschaltung (100) trennbar elektrisch verbunden ist, wobei der Tief-Hochsetzsteller (20) einen zweiten Ausgang (23), der mit dem zweiten Spannungseingang (3) der Treiberschaltung (100) elektrisch verbunden ist, aufweist.

7. Die Treiberschaltung (100) nach Anspruch 6, wobei der Tief-Hochsetzsteller (20) angepasst ist, um eine zweite Spannung (V2) am zweiten Ausgang (23) des Tief-Hochsetzstellers (20) bereitzustellen, wobei die zweite Spannung (V2) größer ist als eine Spannung, die zum ersten Ausgang (22) des Tief-Hochsetzstellers (20) geliefert werden kann.

8. Die Treiberschaltung (100) nach Anspruch 7 und nach einem der Ansprüche 3 bis 5, wobei die zweite Spannung (V2) größer ist als die PRE-Spannung (V_{PRE}).

9. Die Treiberschaltung (100) nach Anspruch 7 oder 8, wobei die zweite Spannung einen Wert von V2 ∈ [11V; 13V] aufweist.

10. Die Treiberschaltung (100) nach einem der Ansprüche 6 bis 9, wobei der elektrisch leitende Pfad zwischen dem zweiten Spannungseingang (3) und dem Spannungsausgang (1) eine erste Diode (14) aufweist.

11. Die Treiberschaltung (100) nach einem der Ansprüche 6 bis 10, wobei der elektrisch leitende Pfad zwischen dem zweiten Spannungseingang (3) und dem Spannungsausgang (1) einen ersten Schalter (11) aufweist.

12. Die Treiberschaltung (100) nach einem der vorhergehenden Ansprüche, wobei der elektrisch leitende Pfad zwischen dem ersten Spannungseingang (2) und dem Spannungsausgang (1) der Treiberschaltung (100) eine zweite Diode (15) aufweist.

13. Die Treiberschaltung (100) nach einem der vorhergehenden Ansprüche, ferner aufweisend zumindest eine Freilaufdiode (17).

14. Die Treiberschaltung (100) nach einem der vorhergehenden Ansprüche, wobei der elektrisch leitende Pfad zwischen dem ersten Spannungseingang (2) und dem Spannungsausgang (1) der Treiberschaltung (100) einen zweiten Schalter (12) aufweist.

15. Ein Verfahren zum Betreiben eines Relais (200) mit einer Treiberschaltung (100) nach den Ansprüchen 11 und 14, aufweisend die folgenden Schritte:
Schließen des ersten Schalters (11) für eine vordefinierte Zeitperiode T, wodurch das Relais (200) in einen geschlossenen Zustand überführt wird;
Schließen des zweiten Schalters (12) nach der vordefinierten Zeitperiode T;
erneutes Öffnen des ersten Schalters (11), nachdem der zweite Schalter (12) geschlossen wurde, während der zweite Schalter (12) in einem geschlossenen Zustand belassen wird.

## Revendications

1. Circuit d'attaque (100) pour l'actionnement d'un relais (200), le circuit d'attaque (100) comprenant :
- une sortie de tension (1) pour la connexion électrique à un relais (200) ;
- une première entrée de tension (2), qui peut être électriquement connectée de façon séparée à la sortie de tension (1) ;
- un convertisseur abaisseur-élévateur (20), comprenant au moins une entrée (21) et une première sortie (22) ;
- une puce de base de système (90), comprenant une borne de sortie (91) adaptée de façon à délivrer une tension, l'entrée au nombre d'au moins une (21) du convertisseur abaisseur-élévateur (20) étant connectée à la borne de sortie (91) de la puce de base de système (90),
la première sortie (22) du convertisseur abaisseur-élévateur (20) étant électriquement connectée à la première entrée de tension (2).

2. Circuit d'attaque (100) selon la revendication 1, dans lequel la puce de base de système (90) et le convertisseur abaisseur-élévateur (20) sont réalisés à l'intérieur d'un seul circuit intégré (95).

3. Circuit d'attaque (100) selon l'une quelconque des revendications précédentes, dans lequel le convertisseur abaisseur-élévateur (20) est adapté de façon à délivrer une tension PRE (V_{PRE}) sur la première sortie (22) du convertisseur abaisseur-élévateur (20).

4. Circuit d'attaque (100) selon la revendication 3, dans lequel, lors du fonctionnement, la tension PRE (V_{PRE}) a une valeur de V_{PRE} ∈ [6 V ; 7 V].

5. Circuit d'attaque (100) selon la revendication 3 ou 4, dans lequel la tension PRE (V_{PRE}) est également utilisée pour la délivrance d'au moins une tension d'alimentation pour un micro-dispositif de commande (300).

6. Circuit d'attaque (100) selon l'une quelconque des revendications précédentes, comprenant de plus une deuxième entrée de tension (3) qui est électriquement connectée de façon séparée à la sortie de tension (1) du circuit d'attaque (100), le convertisseur abaisseur-élévateur (20) comprenant une deuxième sortie (23) qui est électriquement connectée à la deuxième entrée de tension (3) du circuit d'attaque (100).

7. Circuit d'attaque (100) selon la revendication 6, dans lequel le convertisseur abaisseur-élévateur (20) est adapté de façon à délivrer une deuxième tension (V2) sur la deuxième sortie (23) du convertisseur abaisseur-élévateur (20), la deuxième tension (V2) étant supérieure à une tension pouvant être délivrée à la première sortie (22) du convertisseur abaisseur-élévateur (20).

8. Circuit d'attaque (100) selon la revendication 7 et l'une des revendications 3 à 5, dans lequel la deuxième tension (V2) est supérieure à la tension PRE (V_{PRE}) .

9. Circuit d'attaque (100) selon la revendication 7 ou 8, dans lequel la deuxième tension a une valeur de V2 e [11 V ; 13 V].

10. Circuit d'attaque (100) selon l'une des revendications 6 à 9, dans lequel le trajet électriquement conducteur entre la deuxième entrée de tension (3) et la sortie de tension (1) comprend une première diode (14).

11. Circuit d'attaque (100) selon l'une des revendications 6 à 10, dans lequel le trajet électriquement conducteur entre la deuxième entrée de tension (3) et la sortie de tension (1) comprend un premier commutateur (11).

12. Circuit d'attaque (100) selon l'une quelconque des revendications précédentes, dans lequel le trajet électriquement conducteur entre la première entrée de tension (2) et la sortie de tension (1) du circuit d'attaque (100) comprend une deuxième diode (15).

13. Circuit d'attaque (100) selon l'une quelconque des revendications précédentes, comprenant de plus au moins une diode de marche à vide (17).

14. Circuit d'attaque (100) selon l'une quelconque des revendications précédentes, dans lequel le trajet électriquement conducteur entre la première entrée de tension (2) et la sortie de tension (1) du circuit d'attaque (100) comprend un deuxième commutateur (12).

15. Procédé pour l'actionnement d'un relais (200) avec un circuit d'attaque (100) selon les revendications 11 et 14, comprenant les étapes consistant à :
fermer le premier commutateur (11) pendant une période de temps prédéfinie T, de façon à transférer ainsi le relais (200) dans un état fermé ;
fermer le deuxième commutateur (12) après la période de temps prédéfinie T ;
ouvrir à nouveau le premier commutateur (11) après que le deuxième commutateur (12) a été fermé tout en maintenant le deuxième commutateur (12) dans un état fermé.
